# DEMANDE DE BREVET EUROPEEN

(11) **EP 0 665 594 A1**
(43) Date de publication de la demande: **02.08.1995**
(21) Numéro de dépôt: 95400089.9
(22) Date de dépôt: 17.01.1995
(51) Int. Cl.: H01L 25/065, H01L 25/04

(54) **Dispositif tridimensionnel de détection de rayonnement et procédé de fabrication de ce dispositif**

(30) Priorité: 19.01.1994 FR 9400530
(71) Demandeur: COMMISSARIAT A L'ENERGIE ATOMIQUE, F-75015 Paris (FR)
(72) Inventeur: Ravetto, Michel, F-38240 Meylan (FR); Marion, François, F-38120 Saint Egreve (FR); Debono, Jean-Marc, F-38100 Grenoble (FR)
(74) Mandataire: Dubois-Chabert, Guy

(57) **Abrégé**

Le dispositif comprend une matrice de détection (22) recevant le rayonnement et fournissant des signaux représentatifs de celui-ci, un circuit de lecture de ces signaux, comprenant un bloc (24) comportant au moins un empilement de circuits élémentaires de lecture (28) et un composant électrique de sortie (26) relié au circuit de lecture. La matrice de détection et ce composant sont respectivement fixés à deux faces distinctes du bloc. Application à l'imagerie thermique.

## Description

La présente invention concerne un dispositif de détection de rayonnement.

Par "rayonnement", on entend notamment un rayonnement infrarouge, un rayonnement X ou un rayonnement γ.

La présente invention trouve des applications en particulier dans le domaine de l'imagerie thermique et s'applique par exemple à la fabrication d'un convertisseur de rayonnement infrarouge en rayonnement visible.

Du fait de la miniaturisation des circuits intégrés, les facteurs limitatifs des tailles des systèmes comportant de tels circuits sont actuellement l'assemblage et les interconnexions de ces circuits.

On connaît diverses techniques pour réaliser des systèmes complexes et denses, à partir de circuits intégrés.

Une première technique consiste à supprimer les boîtiers de ces circuits, ou puces ("chips"), et à hybrider directement ces puces, au moyen de microbilles de soudure, sur des substrats multicouches permettant de réaliser les interconnexions entre les puces.

Cette première technique connue, appelée technique "flip chip", permet d'hybrider des centaines de puces sur des substrats en céramique (technique "multi chip module").

Cette technique est décrite notamment dans le document US-A-4,202,007.

Une deuxième technique connue, appelée technique "tridimensionnelle", permet de ramener les interconnexions dans un volume réduit.

Cette deuxième technique consiste, par exemple, à coller les puces les unes sur les autres et à former des connexions électriques appropriées sur le bord, ou tranche ("edge"), du bloc ainsi obtenu, de manière à pouvoir interconnecter les puces les unes avec les autres par leurs bords, comme cela apparaît dans le document suivant auquel on se reportera :
(1) "Packaging takes on a new dimension", European semiconductor, Mars 1993, p.21 ou bien encore à hybrider les puces les unes avec les autres au moyen de microbilles d'indium, par une technique d'auto-alignement qui est décrite dans le document suivant auquel on se reportera :
(2) Demande de brevet français n° 8905542 du 26 avril 1989 (voir aussi EP-A-0395488 et US-A-5,131,584).

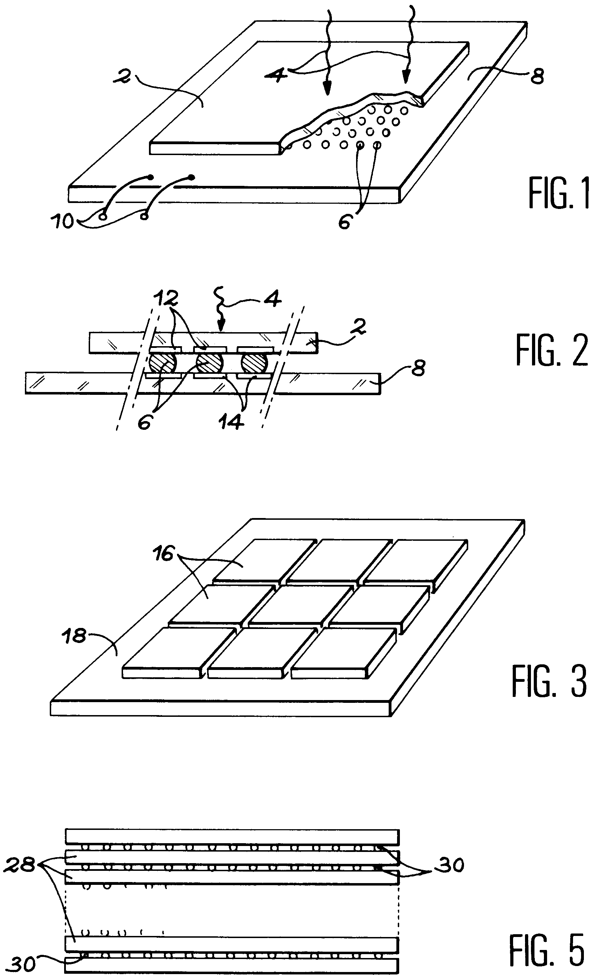

Dans le domaine de la détection infrarouge, on connaît des dispositifs bidimensionnels de détection dans lesquels, comme le montre schématiquement la figure 1, une matrice de détection 2, destinée à détecter un rayonnement 4, est directement hybridée, par l'intermédiaire de microbilles d'indium 6, à un circuit de lecture 8 muni de connexions d'entrée-sortie 10.

Dans le dispositif bidimensionnel de la figure 1, chaque pixel de détection est associé à un pixel de lecture qui est formé sur le circuit 8 et dont la taille est égale au pas de la matrice de détection.

Dans l'exemple de dispositif schématiquement illustré par la figure 2, les pixels de détection 12 de la matrice de détection 2 sont répartis suivant un pas de 40 µm dans les deux directions du plan et la surface maximale disponible pour le pixel de lecture 14 correspondant à un pixel de détection 12, dans le plan focal du dispositif, ne dépasse pas 40x40 µm².

Actuellement, on cherche à obtenir des plans de détection de grande surface, disposant d'une résolution améliorée de l'image et l'on cherche également à traiter, de façon toujours plus performante et plus complète, dans le plan focal d'un dispositif de détection, les signaux fournis par la matrice de détection du dispositif, ce qui nécessite aussi une grande surface.

La figure 3 illustre schématiquement l'obtention d'un plan de détection de grande surface par aboutage de matrices de détection élémentaires 16 sur un circuit de lecture 18.

Pour atteindre les objectifs ci-dessus, il est nécessaire d'une part de diminuer le pas de la matrice de détection et d'autre part de disposer d'une surface beaucoup grande pour chaque pixel de lecture.

Manifestement, ces conditions ne peuvent être simultanément satisfaites dans un dispositif de détection bidimensionnel.

Ainsi, pour une taille de pixel de détection donnée, il n'est pas possible d'augmenter, dans le plan de détection, la taille du pixel de lecture associé à ce pixel de détection.

La présente invention vise précisément à résoudre le problème de l'augmentation de la taille des pixels de lecture.

Pour résoudre ce problème, le dispositif objet de l'invention est un dispositif tridimensionnel.

De façon précise, la présente invention a pour objet un dispositif de détection de rayonnement comprenant :
- une matrice de détection destinée à recevoir le rayonnement et à fournir des signaux représentatifs de ce rayonnement, et
- un circuit de lecture des signaux fournis par la matrice de détection,

ce dispositif étant caractérisé en ce que le circuit de lecture comprend un bloc comportant au moins un empilement de circuits intégrés constituant des circuits élémentaires de lecture, en ce que le dispositif comprend en outre un composant électrique de sortie qui est électriquement relié au circuit de lecture et en ce que la matrice de détection et ce composant sont respectivement fixés à deux faces distinctes du bloc, en ce que les circuits élémentaires de lecture sont hybridés les uns aux autres par des microbilles de soudure et en ce que la matrice de détection et le composant électrique sont hybridés aux faces correspondantes du bloc par des microbilles de soudure.

Selon un mode de réalisation préféré du dispositif objet de l'invention, pour obtenir une plus grande surface pour chaque pixel de lecture, le circuit de lecture des pixels de détection est disposé perpendiculairement au plan de ces pixels de détection.

Plus précisément, selon ce mode de réalisation préféré, la matrice de détection et le composant électrique de sortie sont respectivement fixés à deux faces opposées du bloc, chacune de ces deux faces opposées étant formée de bords juxtaposés des circuits élémentaires de lecture.

Selon un mode de réalisation particulier du dispositif objet de l'invention, le bloc comprend au moins deux empilements fixés l'un à l'autre par des faces de circuits élémentaires de lecture.

Selon un autre mode de réalisation particulier, le bloc comprend au moins deux empilements fixés l'un à l'autre par des faces formées de bords juxtaposés de circuits élémentaires de lecture.

De préférence, les faces des circuits élémentaires de lecture sont électriquement reliées aux bords de ceux-ci pour recevoir les informations fournies par la matrice de détection.

Le dispositif objet de l'invention peut comprendre en outre des moyens de refroidissement prévus pour refroidir le bloc par les quatre autres faces de celui-ci.

Le composant électrique de sortie peut être un support de réseau d'interconnexion.

Ce composant peut être également un composant électronique apte à traiter les signaux que le circuit de lecture est apte à fournir.

La présente invention concerne également un procédé de fabrication du dispositif objet de l'invention, caractérisé en ce qu'il comprend les étapes suivantes :
- on fabrique les circuits intégrés constituant les circuits élémentaires de lecture, chaque circuit intégré comprenant, sur l'une de ses deux faces, des galettes de soudure destinées à l'hybridation de ce circuit intégré à un autre des circuits intégrés,
- on hybride ces circuits élémentaires de lecture les uns aux autres de façon à former l'empilement de circuits intégrés,
- on enrobe de résine les intervalles entre circuits intégrés hybridés,
- on usine deux faces opposées de l'empilement, qui sont formées de bords juxtaposés de circuits élémentaires de lecture, de façon à aplanir ces faces opposées,
- on traite ces deux faces opposées de manière à y former des ensembles de connexions électriques destinées à être respectivement associées à la matrice de détection et au composant électrique de sortie, et
- on hybride la matrice de détection et le composant électrique de sortie aux faces correspondantes de l'empilement.

La présente invention sera mieux comprise à la lecture de la description d'exemples de réalisation donnés ci-après, à titre purement indicatif et nullement limitatif, en faisant référence aux dessins annexés sur lesquels :
· la figure 1, déjà décrite, est une vue schématique d'un dispositif bidimensionnel connu de détection de rayonnement,
· la figure 2, déjà décrite, est une vue en coupe schématique d'un tel dispositif bidimensionnel,
· la figure 3, déjà décrite, est une vue schématique en perspective d'un autre dispositif bidimensionnel connu de détection de rayonnement,
· la figure est une vue schématique d'un mode de réalisation particulier du dispositif tridimensionnel de détection de rayonnement objet de l'invention,
· la figure 5 illustre schématiquement une technique utilisable pour la fabrication du dispositif de la figure 4,
· la figure 6 illustre schématiquement des connexions électriques formées sur les circuits élémentaires de lecture que comporte le dispositif de la figure 4,
· la figure 7 illustre schématiquement l'étape d'un procédé conforme à l'invention, dans laquelle on réalise, sur une plaquette ("Wafer") de silicium, des circuits intégrés permettant de réaliser un dispositif conforme à l'invention du genre de celui de la figure 4,
· la figure 8 est une vue en coupe de cette plaquette de silicium dans laquelle sont formées ces circuits intégrés,
· la figure 9 illustre schématiquement la formation de diverses couches sur les deux faces de la plaquette de silicium,
· la figure 10 illustre schématiquement un circuit intégré que l'on a découpé à partir de cette plaquette,
· la figure 11 illustre schématiquement une étape du procédé conforme à l'invention, dans laquelle les circuits intégrés sont hybridés les uns aux autres,
· la figure 12 illustre schématiquement une autre étape de ce procédé, selon laquelle on réalise un enrobage de résine de chaque intervalle d'hybridation, ainsi qu'une autre étape selon laquelle on réalise un aplanissement des bords des circuits intégrés assemblés,
· la figure 13 illustre schématiquement une autre étape selon laquelle les faces aplanies sont pourvues de connexions électriques, l'une des ces faces étant également pourvue de galettes de soudure,
· la figure 14 illustre schématiquement un autre dispositif tridimensionnel conforme à l'invention, et
· la figure 15 illustre également, de façon schématique, un autre dispositif tridimensionnel conforme à l'invention.

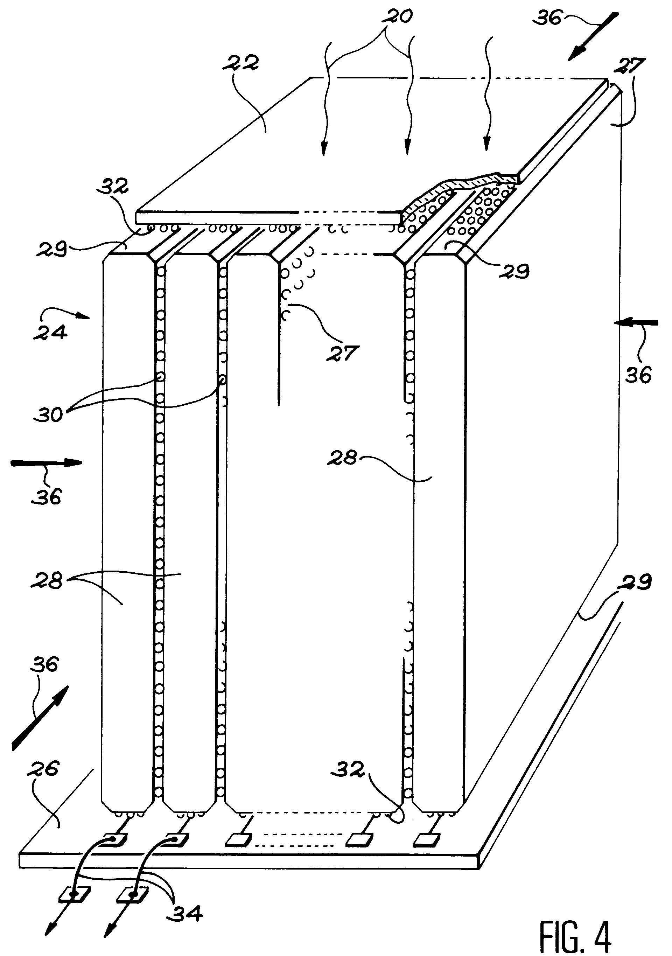

Le dispositif de détection conforme à l'invention, qui est schématiquement représenté en perspective sur la figure 4, est destiné à détecter un rayonnement 20, par exemple, un rayonnement infrarouge.

Ce dispositif de la figure 4 comprend :
- une matrice 22 de détection du rayonnement qui reçoit ce rayonnement et fournit des signaux représentatifs de ce rayonnement,
- un circuit 24 de lecture (et éventuellement de traitement après lecture) des signaux fournis par la matrice de détection, et
- un support de réseau d'interconnexion 26.

Le circuit 24 de lecture (et éventuellement de traitement) est un empilement de circuits intégrés 28, ou puces ("chips"), qui constituent des circuits élémentaires de lecture (et éventuellement de traitement) des signaux fournis par la matrice de détection.

Cet empilement forme un bloc sensiblement parallélépipédique qui a donc six faces.

Les faces 27 des circuits élémentaires 28 sont parallèles les unes aux autres et perpendiculaires au plan de la matrice de détection 22 et au support de réseau d'interconnexion 26.

La matrice 22 et le support 26 sont respectivement fixés à deux faces opposées du bloc 24, chacune de ces deux faces opposées étant formées de bords, ou tranches ("edges"), juxtaposés 29 des circuits intégrés 28, comme on le voit sur la figure 4.

Les circuits intégrés 28 sont hybridés les uns aux autres par des microbilles de soudure 30.

De la même façon, la matrice de détection 22 et le support 26 sont hybridés par d'autres microbilles de soudure 32 aux tranches des circuits intégrés qui leurs sont associées.

Les informations issues de la matrice de détection sont transmises aux faces 27 des circuits intégrés 28 par l'intermédiaire des tranches correspondantes de ces circuits et de connexions électriques (non représentées sur la figure 4), qui vont de ces tranches aux faces de ces circuits intégrés, en vue d'une lecture (et éventuellement d'un traitement après lecture) de ces informations dans ces circuits intégrés.

Le support de réseau d'interconnexion 26 constitue un composant électrique passif qui a pour fonction d'assurer les interfaces électriques et mécaniques entre l'empilement de circuits intégrés 28 et l'extérieur du dispositif de la figure 4, par l'intermédiaire de connexions d'entrée-sortie telles que les connexions 34 de la figure 4.

Dans un mode de réalisation particulier non représenté, le support de réseau d'interconnexion 26 est remplacé par un composant électrique actif, apte à traiter des signaux fournis par les circuits intégrés 28, par exemple un écran de visualisation des objets (non représentés) émettant le rayonnement infrarouge 20.

On obtient ainsi un dispositif de conversion de rayonnement infrarouge en lumière visible.

On précise que le dispositif de la figure 4 peut être muni de moyens symbolisés par des flèches 36 et destinés à refroidir ce dispositif, par l'intermédiaire des quatre autres faces du bloc 24 (faces qui ne sont fixées ni à la matrice 22 ni au support 26).

La réalisation de l'empilement 24 doit respecter à la fois le pas de la matrice de détection 22 et le pas des connexions réalisées sur le support de réseau d'interconnexion.

Avec le dispositif conforme à l'invention qui est représenté sur la figure 4, la matrice de détection est lue par des circuits qui disposent d'une surface beaucoup plus grande que dans l'art antérieur, puisqu'on utilise un assemblage tridimensionnel de circuits intégrés dont les plans, sur lesquels s'effectue cette lecture, sont perpendiculaires à la matrice de détection.

Le dispositif de la figure 4 permet ainsi d'intégrer un maximum de fonctions dans un très faible volume et de réduire les longueurs des interconnexions entre les circuits intégrés utilisés et donc de limiter les capacités de lignes, qui sont des facteurs limitatifs des vitesses de commutation des dispositifs de détection connus.

On décrira dans ce qui suit un procédé de fabrication du dispositif de la figure 4 mais on précise dès à présent que ce procédé utilise une technique d'hybridation par auto-alignement, qui est décrite dans le document (2) mentionné plus haut.

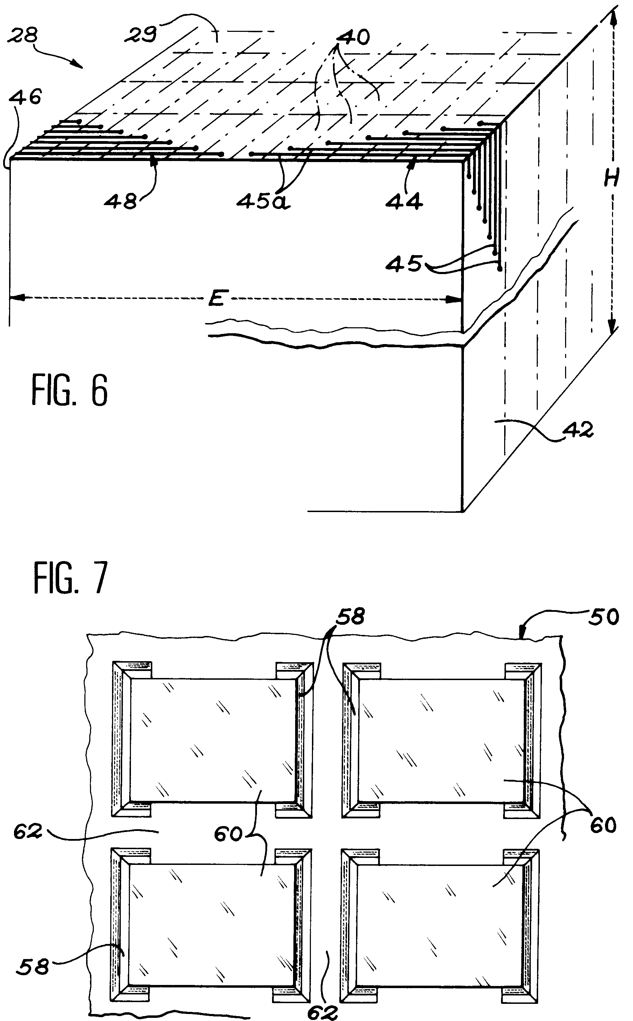

La figure 5, qui illustre très schématiquement l'hybridation des puces 28, par des microbilles de soudure 30, est à rapprocher de la figure 7 du document (2).

Une telle technique d'assemblage est particulièrement intéressante lorsqu'on souhaite, comme c'est le cas ici, obtenir une très grande précision sur le positionnement relatif des puces 28 et l'intervalle entre ces puces 28.

La figure 6 est une vue schématique et partielle, en perspective, d'un exemplaire des puces 28 utilisées dans le dispositif de la figure 4.

On voit sur la figure 6 un bord 29 de la puce 28, qui est destiné à être connecté à la matrice de détection.

On a représenté des zones 40 de ce bord 29 qui correspondent respectivement à des pixels de détection de la matrice de détection 22.

A titre purement indicatif et nullement limitatif, chaque pixel de détection est un carré de 35 µm de côté (les zones 40 étant représentées sous forme de rectangles pour plus de clarté de la figure 6), l'épaisseur E de chaque puce 28 vaut 490 µm et correspond ainsi à quatorze colonnes de pixels de détection et la hauteur H de chaque puce 28 peut aller de quelques millimètres à quelques centimètres.

Pour chaque rangée de quatorze zones 40 de la puce 28, on distingue les sept zones de gauche et les sept zones de droite que l'on voit sur la figure 6.

Les sept pixels de détection correspondant aux sept zones de droite sont lus sur la face 42 de la puce 28, les signaux correspondants étant transmis par sept connexions électriques référencées 44, qui vont du bord 29 à la face 42, comme on le voit sur la figure 6.

L'autre face 46 de la puce 28 sert de réseau d'interconnexion et les signaux correspondant aux sept pixels de détection associés aux sept zones de gauche parviennent à ce réseau d'interconnexion par l'intermédiaire de sept connexions électriques 48, qui vont du bord 29 à la face 46, comme on le voit sur la figure 6.

Sur la face 42 de la puce 28, on lit également sept pixels de détection associés à la puce (non représentée) adjacente à la face 42 (mais bien entendu dans une zone différente de celle correspondant aux sept pixels associés à cette puce 28), les signaux correspondants parvenant à la face 42 par l'intermédiaire d'un réseau d'interconnexion formé sur une face de cette puce adjacente, face qui est l'homologue de la face 46 de la puce 28.

De même, les sept autres pixels associés aux connexions 48 de la puce 28 sont traités sur une face de la puce (non représentée) adjacente à la face 46, à laquelle ils parviennent par l'intermédiaire du réseau d'interconnexion formé sur cette face 46.

Ainsi, sur chaque face du genre de la face 42, on dispose d'une grande surface de lecture pour un pixel de détection, à savoir 35xH/14 µm² dans l'exemple donné ci-dessus.

Du côté du support de réseau d'interconnexion 26, des connexions électriques du même genre que les connexions 44 et 48 sont prévues sur les tranches et les faces des puces 28 pour assurer les liaisons voulues entre les circuits de lecture et le support de réseau d'interconnexion 26.

On explique dans ce qui suit un procédé de fabrication du dispositif représenté sur la figure 4.

Cette fabrication utilise une plaquette ("wafer") de silicium 50 et l'on traite les deux faces de cette plaquette 50 comme on l'explique ci-après.

On commence d'abord par créer sur chacune des faces de la plaquette 50 des motifs d'alignement (non représentés) pour le photo-masquage et la gravure que l'on réalise ultérieurement.

Les positions respectives de ces motifs d'alignement sont parfaitement définies (avec les équipements actuellement utilisés, on aboutit à des alignements standards à 2 µm près).

On crée également des zones de raccordement 58, sur lesquelles on réalisera les raccordements électriques entre les circuits ultérieurement formés sur les bords et les faces des puces dont il a été question plus haut.

Ces motifs d'alignement et ces zones de raccordement peuvent être réalisés par gravure chimique du silicium.

On réalise ensuite des éléments électriques actifs et des éléments électriques passifs respectivement sur les deux faces de la plaquette 50 de silicium.

Ainsi, sur l'une des faces de cette plaquette 50, on réalise les motifs élémentaires 60 constituant les circuits élémentaires de lecture des pixels de détection et, sur l'autre face, on réalise les réseaux d'interconnexion dont il a été question plus haut à propos de la face 46 de la figure 6.

Sur les deux faces de la plaquette 50, on réalise également des lignes de connexions électriques du genre des lignes 45 de la figure 6, qui existent sur les deux faces 42 et 46 de la plaquette 28 et qui font partie des connexions référencées 44 et 48 sur la figure 6.

On notera que les motifs élémentaires 60, munis des zones de raccordement 58, sont espacés les uns des autres par des zones de séparation 62 appelées "chemins de découpe" et réservées à la séparation des puces les unes des autres.

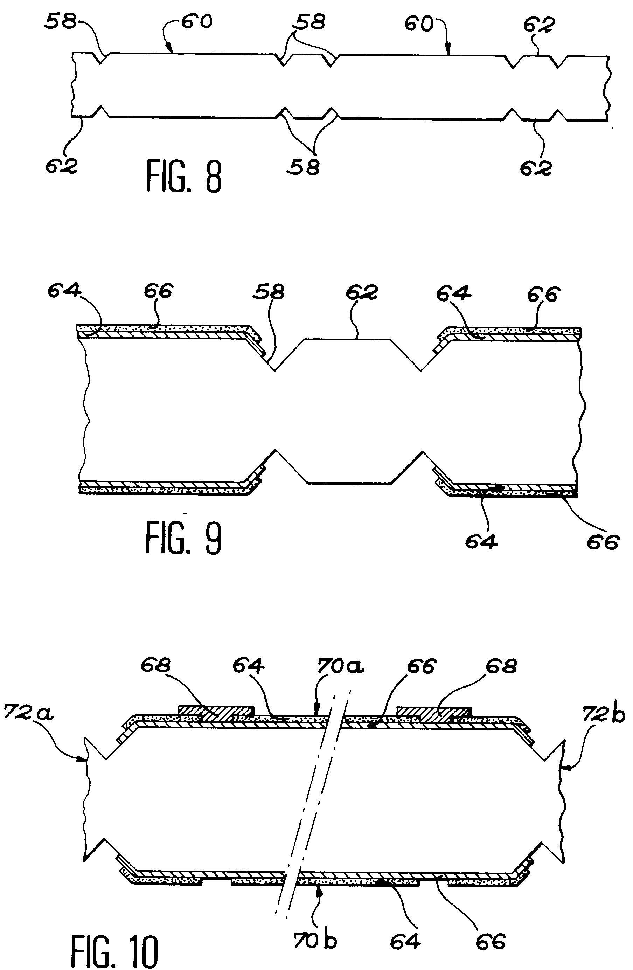

La figure 8 est une vue en coupe de la plaquette 50 qui montre les zones de raccordement 58, les motifs élémentaires 60 séparés les uns des autres par les chemins de découpe 62 et destinés à former, après séparation, les puces 28.

Les traitements des deux faces de la plaquette 50 de silicium peuvent être réalisés d'abord sur une face puis sur l'autre face soit sur les deux faces à la fois, soit en réalisant certaines opérations de traitement en même temps sur les deux faces pour profiter au mieux des dépôts et gravures successifs que l'on cherche à faire sur ces faces.

La figure 9 illustre de façon schématique et partielle des couches respectivement conductrices et isolantes 64 et 66 que l'on est ainsi amené à former sur ces faces de la plaquette 50 de silicium.

On précise que les opérations successives de dépôt et de gravure, dont le nombre est fonction du type de circuits à former, se déroulent jusqu'à la formation de galettes de soudure (par exemple en indium) qui a lieu sur une seule des deux faces de la plaquette de silicium (en vue de réaliser ultérieurement les hybridations des puces, dont il a été question plus haut).

On sépare ensuite les unes des autres les puces 28 ainsi obtenues comme l'illustre schématiquement la figure 10.

Il s'agit d'une opération standard de séparation qui s'effectue dans deux directions perpendiculaires, à l'intérieur des chemins de découpe 62 prévus à cet effet sur la plaquette de silicium 50.

On voit sur la figure 10 que chaque puce 28 ainsi découpée comprend des couches conductrices (métalliques) 66 surmontées de couches de passivation 64 (isolantes), sur ses deux faces.

Les couches de passivation 64 comportent des ouvertures laissant apparaître des surfaces des couches 66 (formant des connexions électriques).

Comme on le voit sur la figure 10, l'une des deux faces de la puce 28 comporte aussi des galettes 68 (ou éléments de soudure) en indium destinées à l'hybridation de cette puce à une puce adjacente, comme on le verra par la suite.

Ces galettes 68 reposent sur les couches de passivation 64 et sont en contact, à travers les ouvertures prévues dans ces dernières, avec les couches métalliques correspondantes.

La face de la puce 28 qui comporte ces galettes de soudure porte la référence 70a tandis que la face opposée de la puce 28 porte la référence 70b.

Les bords de la puce 28 résultant de la séparation de cette puce des puces adjacentes portent respectivement les références 72a et 72b.

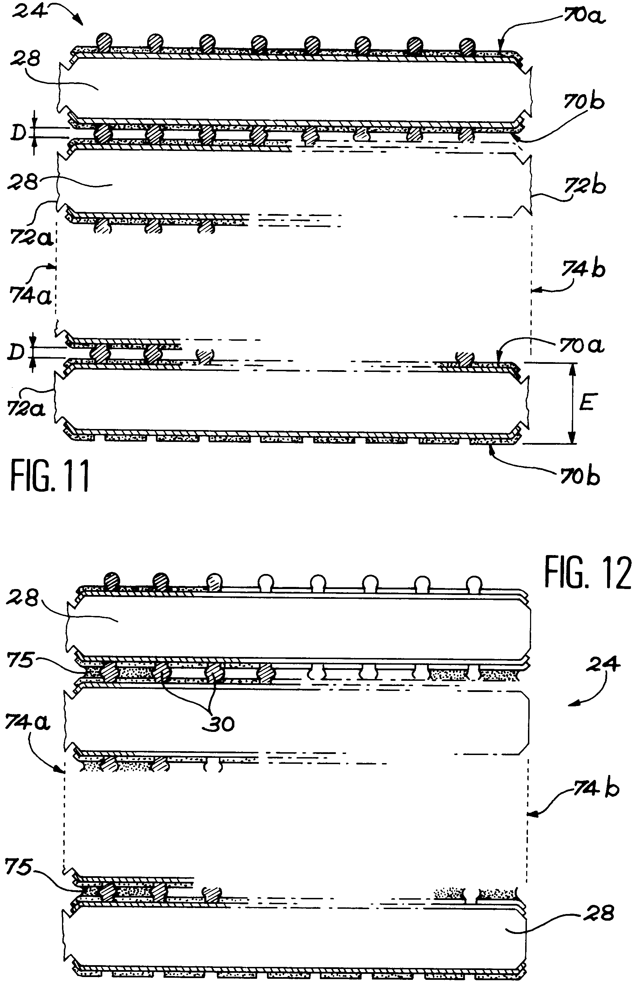

Une fois les galettes de soudure formées, les puces 28 sont toutes alignées et empilées, comme on le voit sur la figure 11, de façon que les faces 70a soient au contact des faces 70b dans l'empilement.

Ensuite, ces puces 28 sont hybridées les unes aux autres grâce aux galettes de soudure, selon l'enseignement du document (2) mentionné plus haut.

Les surfaces des couches métalliques, qui ne portent pas de galettes de soudure, sont bien entendu mouillables par le matériau de ces galettes de soudure pour permettre l'hybridation d'une puce à la puce adjacente.

La distance finale D entre deux puces adjacentes est parfaitement définie et reproductible.

A titre purement indicatif et nullement limitatif, on utilise des plaquettes de silicium de l'ordre de 100 mm de diamètre et de l'ordre de 500 µm d'épaisseur (à 5 µm près) et la distance D entre deux puces adjacentes est de l'ordre de 10 µm (à 1 µm près).

Le bloc 24 ainsi obtenu comporte une face 74a constituée de tout les bords 72a des puces et une face 74b opposée à la précédente, composée de tous les bords 72b de ces puces.

L'étape suivante du procédé consiste à réaliser un enrobage de résine de l'intervalle d'hybridation de soudure entre deux puces adjacentes.

Plus précisément, comme l'illustre schématiquement la figure 12, on dépose une couche 75 de résine au niveau de chaque intervalle entre les puces et cette résine mouille les faces 70a et 70b adjacentes jusqu'aux microbilles de soudure 30 (résultant de l'opération d'hybridation) les plus externes de l'empilement.

Cet enrobage de résine a pour fonction de protéger les éléments (actifs et/ou passifs) réalisés sur les faces 70a et 70b des puces et de maintenir mécaniquement ces puces les unes par rapport aux autres pour les étapes ultérieures du procédé.

La figure 12 illustre également de façon schématique l'étape suivante du procédé, qui consiste en un rodage et un polissage mécaniques des faces 74a et 74b du bloc 24, correspondant aux bords 72a et 72b, de manière à éliminer les résidus de découpe dans les zones de raccordement, et également en une préparation des surfaces ainsi rodées et polies pour les étapes technologiques suivantes.

On précise que les deux autres faces du bloc sont traitées comme ces faces 74a et 74b dans le cas où il est nécessaire d'y réaliser des circuits électriques et, dans le cas contraire, restent dans l'état où elles sont après découpe.

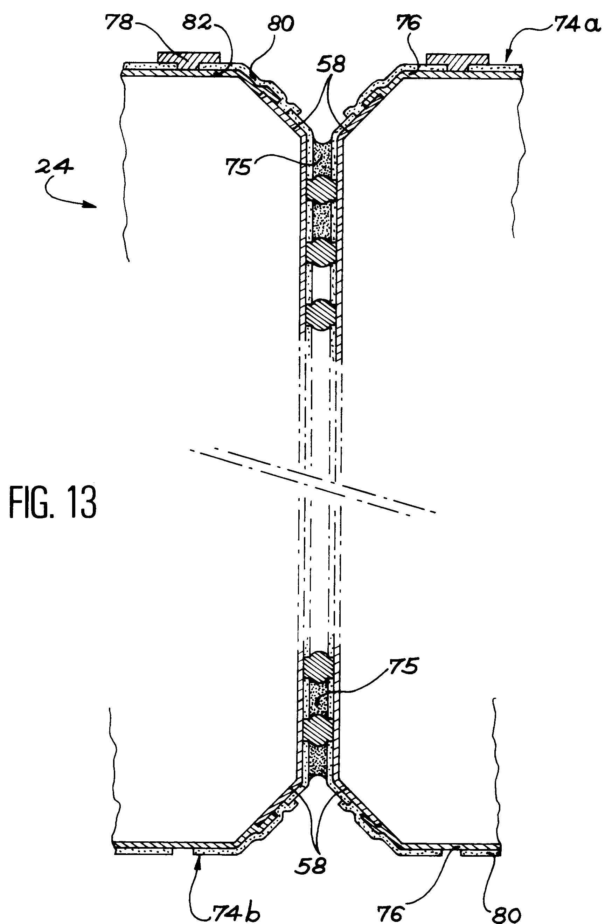

Dans l'étape suivante, on traite les faces 74a et 74b du bloc 24 comme l'illustre schématiquement la figure 13.

Ce traitement est beaucoup plus simple et surtout moins critique que celui qui a été réalisé auparavant sur les faces 70a et 70b des puces 28.

Il s'agit en fait de réaliser des réseaux d'interconnexion sans fonction active, cette réalisation étant réduite, dans l'exemple donné,
· à trois niveaux de masquage sur la face 74b correspondant au support de réseau d'interconnexion pour réaliser :
   - une première métallisation (non représentée) correspondant aux lignes de connexion électrique référencées 45a sur la figure 6, qui prolongent respectivement les lignes 45 pour former les connexions 44 de la figure 6,
   - une deuxième métallisation spécifique pour former des couches métalliques 76 destinées à recevoir les billes d'indium 32 formées lors de l'hybridation du support de réseau d'interconnexion à cette face 74b, et
   - une passivation entre les deux métallisations, donnant des couches de passivation 80 qui présentent des ouvertures pour permettre un contact entre les microbilles de soudure et les couches 76 sur la face 74b, et
· seulement à cinq niveaux de masquage pour l'autre face 74a du bloc 24, à savoir les trois niveaux de masquage précédemment mentionnés et deux autres niveaux de masquage pour réaliser des galettes de soudure 82 en indium, destinées à l'hybridation de la face 74a à la matrice de détection 22 de la figure 4.

On précise que l'alignement des niveaux de masquage se fait à partir des motifs d'alignement qui ont été engendrés lors du traitement des faces des puces et qui apparaissent maintenant sur les zones de raccordement 58.

Dans cette étape de traitement des faces 74a, et 74b, on fait encore en sorte de profiter au mieux des dépôts et gravures que l'on retrouve sur chacune de ces faces 74a et 74b, en particulier les dépôts de première métallisation, les dépôts de deuxième métallisation et la passivation.

On a ainsi achevé la fabrication du bloc 24 de la figure 4, portant les circuits de lecture et d'interconnexion, ce bloc formant une interface entre la matrice de détection (sur laquelle on a défini des surfaces mouillables associées aux galettes de soudure 78 réalisées sur le bloc 24) et le support de réseau d'interconnexion 26 (sur lequel on a réalisé des galettes de soudure correspondant aux surfaces mouillables des couches métalliques 76 réalisées sur la face 74b du bloc 24).

Comme on l'a vu plus haut, ce support de réseau d'interconnexion constitue une interface entre le dispositif de la figure 4 et l'extérieur.

Ensuite, on réalise une hybridation, par microbilles de soudure, de la face 74a du bloc 24 avec la matrice de détection 22 et de la face 74b du bloc 24 avec le support de réseau d'interconnexion 26.

A ce sujet, on se référera encore au document (2).

On obtient ainsi le dispositif représenté sur la figure 4.

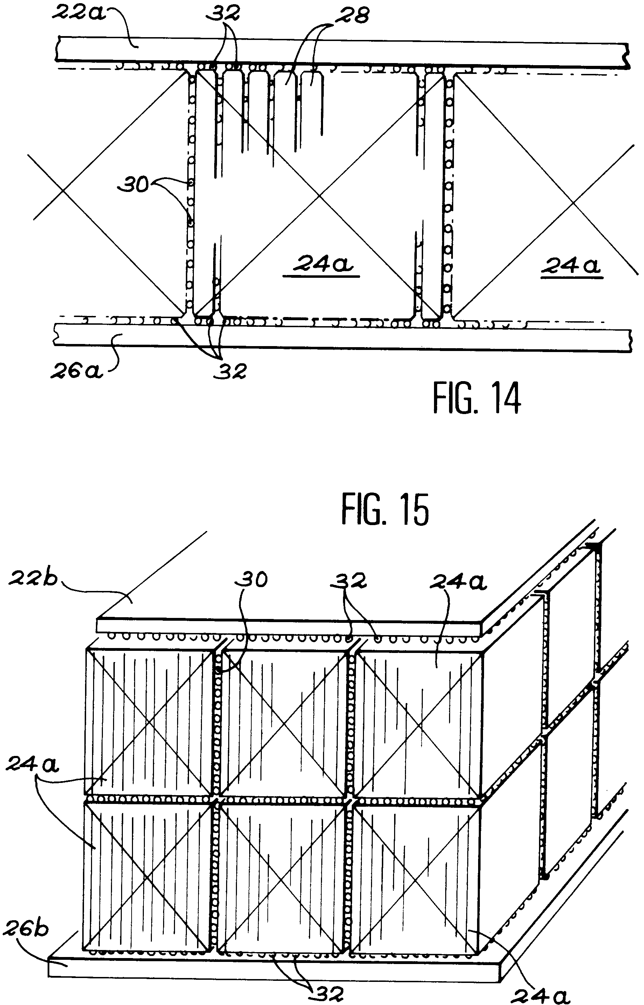

Un autre dispositif de détection conforme à l'invention est schématiquement et partiellement représenté sur la figure 14 et comprend, au lieu d'un seul bloc comme dans le cas de la figure 4, une pluralité de bloc 24a composé chacun de puces 28 (comme le bloc 24 de la figure 4).

Ces blocs 24a sont hybridés par des microbilles de soudure 30 et forment une rangée qui est insérée entre une matrice de détection 22a et un support de réseau d'interconnexion 26a, ces derniers étant hybridés par des microbilles de soudure 32 aux différentes puces 28 des blocs 24a.

La figure 15 illustre schématiquement et partiellement un autre dispositif de détection conforme à l'invention qui comprend non pas une seule mais plusieurs, par exemple deux, rangées de blocs 24a, les blocs d'une rangée étant respectivement reliés, par des microbilles de soudure 32, aux blocs de l'autre rangée, chaque bord d'une puce d'un bloc d'une rangée étant ainsi hybridée au bord d'une puce d'un bloc de l'autre rangée.

L'ensemble de blocs obtenu est encore hybridé d'un côté à une matrice de détection 22b et de l'autre à un support de réseau d'interconnexion 26b par des microbilles de soudure 32.

Pour les hybridations relatives aux dispositifs des figures 14 et 15 on se référera encore au document (2).

D'autres dispositifs conformes à l'invention sont réalisables : on peut fabriquer un bloc comprenant un ou plusieurs empilements de puces et hybrider, à deux faces choisies de ce bloc, une matrice de détection et un support de réseau d'interconnexion.

## Revendications

1. Dispositif de détection de rayonnement comprenant :
- une matrice de détection (22) destinée à recevoir le rayonnement et à fournir des signaux représentatifs de ce rayonnement, et
- un circuit (24) de lecture des signaux fournis par la matrice de détection,
ce dispositif étant caractérisé en ce que le circuit de lecture comprend un bloc comportant au moins un empilement de circuits intégrés (28) constituant des circuits élémentaires de lecture, en ce que le dispositif comprend en outre un composant électrique de sortie (26) qui est électriquement relié au circuit de lecture, en ce que la matrice de détection et ce composant sont respectivement fixés à deux faces distinctes du bloc, en ce que les circuits élémentaires de lecture (28) sont hybridés les uns aux autres par des microbilles de soudure (30) et en ce que la matrice de détection (22) et le composant électrique (26) sont hybridés aux faces correspondantes du bloc par des microbilles de soudure (32).

2. Dispositif selon la revendication 1, caractérisé en ce que la matrice de détection (22) et le composant électrique de sortie (26) sont respectivement fixés à deux faces opposées du bloc, chacune de ces deux faces opposées étant formée de bords juxtaposés (29) des circuits élémentaires de lecture (28).

3. Dispositif selon l'une quelconque des revendications 1 et 2, caractérisé en ce que le bloc comprend au moins deux empilements (24a) fixés l'un à l'autre par des faces de circuits élémentaires de lecture.

4. Dispositif selon l'une quelconque des revendications 1 à 3, caractérisé en ce que le bloc comprend au moins deux empilements (24a) fixés l'un à l'autre par des faces formées de bords juxtaposés de circuits élémentaires de lecture.

5. Dispositif selon l'une quelconque des revendications 1 à 4, caractérisé en ce que les faces (42, 46) des circuits élémentaires de lecture (28) sont électriquement reliées aux bords de ceux-ci (29) pour recevoir les informations fournies par la matrice de détection (22).

6. Dispositif selon l'une quelconque des revendications 1 à 5, caractérisé en ce qu'il comprend en outre des moyens de refroidissement (36) prévus pour refroidir le bloc par les quatre autres faces de celui-ci.

7. Dispositif selon l'une quelconque des revendications 1 à 6, caractérisé en ce que le composant électrique de sortie est un support de réseau d'interconnexion (26).

8. Dispositif selon l'une quelconque des revendications 1 à 6, caractérisé en ce que le composant électrique de sortie est un composant électronique apte à traiter les signaux que le circuit de lecture est apte à fournir

9. Procédé de fabrication du dispositif selon la revendication 1, caractérisé en ce qu'il comprend les étapes suivantes :
- on fabrique les circuits intégrés constituant les circuits élémentaires de lecture (28), chaque circuit intégré comprenant, sur l'une de ses deux faces, des galettes de soudure (68) destinées à l'hybridation de ce circuit intégré à un autre des circuits intégrés,
- on hybride ces circuits élémentaires de lecture (28) les uns aux autres de façon à former l'empilement (24) de circuits intégrés,
- on enrobe de résine (75) les intervalles entre circuits intégrés hybridés,
- on usine deux faces opposées (74a, 74b) de l'empilement, qui sont formées de bords juxtaposés de circuits élémentaires de lecture, de façon à aplanir ces deux faces opposées,
- on traite ces deux faces opposées de manière à y former des ensembles de connexions électriques destinés à être respectivement associés à la matrice de détection (22) et au composant électrique de sortie (26), et
- on hybride la matrice de détection et le composant électrique de sortie aux faces correspondantes de l'empilement.
